(19) **Europäisches Patentamt**
**European Patent Office**
**Office européen des brevets**

(11) **EP 4 611 504 A1**

(12) **EUROPEAN PATENT APPLICATION**

(43) Date of publication:
**03.09.2025   Bulletin 2025/36**

(21) Application number: **25157361.4**

(22) Date of filing: **12.02.2025**

(51) International Patent Classification (IPC):
**H10D 30/01** (2025.01)     **H10D 30/66** (2025.01)
**H10D 62/10** (2025.01)     **H10D 64/00** (2025.01)
**H10D 64/27** (2025.01)

(52) Cooperative Patent Classification (CPC):
**H10D 30/0297; H10D 30/668; H10D 62/116;
H10D 64/117; H10D 64/518**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.02.2024  US 202418590785**

(71) Applicant: **STMicroelectronics International N.V.**
**1228 Plan-les-Ouates, Geneva (CH)**

(72) Inventors:
• LIAO, Chia-Liang
  769133 SINGAPORE (SG)
• NGWAN, Voon Cheng
  732686 SINGAPORE (SG)
• ENEA, Vincenzo
  96100 SIRACUSA (IT)

(74) Representative: **Studio Torta S.p.A.**
**Via Viotti, 9**
**10121 Torino (IT)**

(54) **AIR-GAP IN TRENCH FIELD PLATE POWER MOSFET FOR REDUCED POWER LOSS PERFORMANCE**

(57)     A MOSFET power device, comprising a substrate (110). The substrate includes: a recess in a first surface (112) of the substrate, the first surface extending in a first direction, the recess having sidewalls (115) extending in a second direction transverse the first direction and including a second surface (114) extending in the first direction between the sidewalls; an insulating layer (124, 125) on the first surface of the substrate and in the recess; a polysilicon region (130) in the insulating layer, the polysilicon region extending in the second direction; and an air gap (160) in the insulating layer between the polysilicon region and the substrate, the air gap extending in the second direction.

FIG. 1

EP 4 611 504 A1

**Description**

**BACKGROUND**

**Technical Field**

The present invention regards a power Metal Oxide Semiconductor Field Effect Transistor (MOSFET) device including at least one air gap spaced from a source polysilicon region in a recessed substrate.

**Background**

During operation of a MOSFET device, there is an on-resistance or Ron value between a drain of the device and a source of the device. The Ron value contributes to the power consumption of the device. Thus, a lower Ron value results in a lower loss of power of the device.

A Trench Field Plate Power MOSFET device is a low voltage power MOSFET device with a lower Ron value. A dielectric material of the device contributes to the performance of the device and gate capacitance. The dielectric material often used in the device is silicon dioxide having a dielectric constant of k equal to 3.9.

When silicon dioxide is replaced with an insulator material having a lower dielectric constant, the on-state resistance contributed by a silicon component (Rsil) is lowered, measured by a unit denoted by $m\Omega*mm^2$.

$$R_{on} \propto \frac{0.72}{\gamma_{FP}} SiLimit$$

$$\gamma_{FP} = \frac{t_{FP}}{2W_i + W_n} = \frac{1}{2\sqrt{\frac{2}{3}\frac{\varepsilon_i}{\varepsilon_s} + \frac{W_n}{t_{FP}}}}$$

wherein $\gamma_{FP}$ is the cell aspect ratio of the field plate, $\varepsilon_S$ and $\varepsilon_i$ are dielectric constants of the semiconductor and insulator, respectively, $t_{FP}$ is field plate thickness, $W_n$ is the n-column width, and $W_i$ is insulator width.

The lowest possible dielectric constant is k=1 from air.

It is thus desirable to form packets of air, in particular during back end of line copper interconnects to lower the effective capacitance to reduce signal propagation RC (Resistance-Capacitance) delay.

**SUMMARY**

According to the invention, a power MOSFET device and a manufacturing method thereof are provided, as defined in the attached claims.

**BRIEF DESCRIPTION OF THE DRAWINGS**

For a better understanding of the present invention, embodiments thereof are now described, purely by way of non-limiting examples, with reference to the attached drawings, wherein:

Figure 1 is a power MOSFET device according to an embodiment.

Figure 2 is a power MOSFET device including a nitride layer, according to another embodiment.

Figures 3A-3R are steps of a method of manufacturing the device of Figure 2.

Figures 4A-4F are steps of a method of manufacturing the device of Figure 1.

**DETAILED DESCRIPTION**

The following description refers to the arrangement shown; consequently, expressions such as "above", "below", "upper", "lower", "top", "bottom", "right", "left" relate to the accompanying figures and are not to be interpreted in a limiting manner.

Furthermore, the dimensions of the various regions and structures are not necessarily to scale and have sometimes been exaggerated or reduced to allow for their representation and/or to facilitate understanding.

The present disclosure is directed to a power MOSFET device including at least one air gap and a buried polysilicon source in an insulating layer. The air gap is between the buried polysilicon source and a recess sidewall in a substrate.

In particular, the present disclosure is directed to a device that includes a power MOSFET that includes a substrate having a recess in a first surface of the substrate, the first surface extending in a first direction, the recess having sidewalls extending in a second direction transverse the first direction, the recess including a second surface extending in the first direction between the sidewalls. The device includes an insulating layer on the first surface of the substrate and in the recess, a first polysilicon region in the insulating layer, the first polysilicon region extending in the second direction for a first dimension, and an air gap in the insulating layer between the first polysilicon region and the substrate, the air gap extending in the second direction for a second dimension being less than the first dimension.

An air gap in the field plate region replaces silicon dioxide with air, achieving a better Rsil (On-state resistance contributed by silicon component) performance. The air gap (k=1) in a field plate power MOSFET device contributes to overcome the Si-limit.

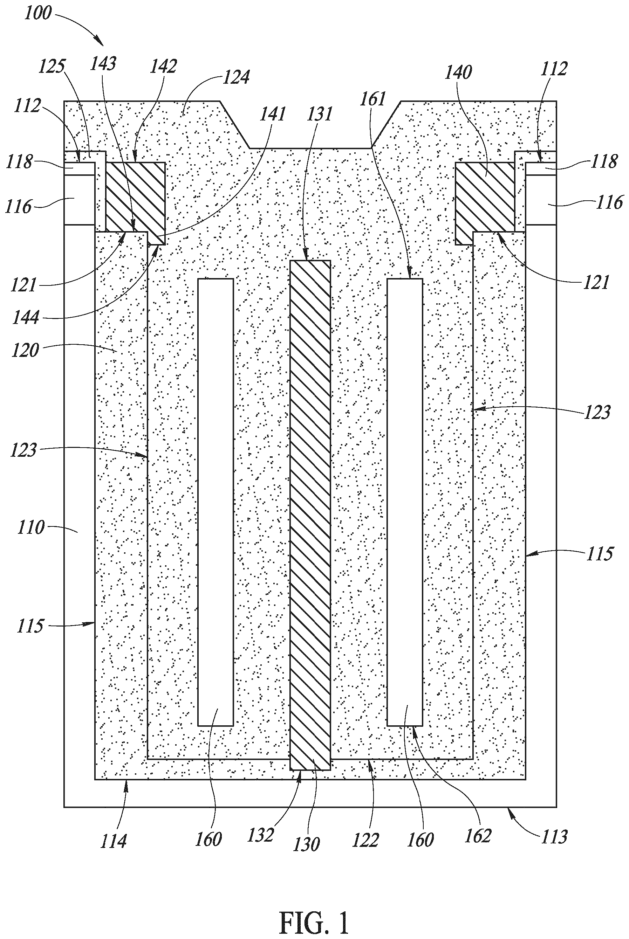

Figure 1 shows a power MOSFET device 100, in the following also indicated as device 100, including a first insulating layer 120 on a substrate 110 that is recessed and a second insulating layer 124 on the first insulating layer 120.

A polysilicon source 130 is in the second insulating layer 124 and extends in the first insulating layer 120. The polysilicon source 130 has a top surface 131 opposite a bottom surface 132.

The second insulating layer 124 has at least one air gap 160 between sidewalls 115 of the substrate 110 and the polysilicon source 130.

At least one gate 140 is on the first insulating layer 120. A third insulating layer 125 separates the gate 140 from the substrate 110.

A body region 116 and a source region 118 are on the first insulating layer 120, the source region 118 being on the body region 116.

Substrate 110 in practice operates as a drain region and the power MOSFET device 100 is of vertical type.

The substrate 110 has a first or top surface 112 opposite a second or bottom surface 113. A recess or trench extends from the first surface 112 of the substrate 110 in a vertical or first direction. The recess forms the sidewalls 115 of the substrate 110 which extend, opposite each other, in the vertical direction to a third or bottom surface 114 of the recess. The bottom surface 114 of the recess extends between the sidewalls 115 in a horizontal or second direction transverse the first direction.

The bottom surface 114 of the recess extends in the horizontal direction for a first dimension or width. The sidewalls 115 extend in the first direction for a second dimension. For example, the first dimension of the bottom surface 114 the recess is less than the second dimension of the sidewalls 115.

The substrate 110 is silicon, or other suitable semiconductor material.

The substrate 110 includes the source region 118 on the body region 116. The source region 118 is adjacent to the top surface 112 of the substrate 110.

The first insulating layer 120 may be called a field plate oxide layer 120 and is in the recess. The first insulating layer 120 entirely coats or covers the bottom surface 114 of the recess. The sidewalls 115 are partially covered by the first insulating layer 120. Said differently, a first or top surface 121 of the first insulating layer 120 does not extend past the first surface 112 of the substrate 110. The top surface 121 of the first insulating layer 120 is transverse to the sidewalls 115 of the substrate 110.

The top surface 121 of the first insulating layer 120 may be adjacent and below the body region 116. Said differently, the first insulating layer 120 may not contact the body region 116.

The first insulating layer 120 includes second or lateral surfaces 123 transverse to the first surface 121 of the first insulating layer 120. The lateral surfaces 123 of the first insulating layer 120 extend to a third or bottom surface 122 of the first insulating layer 120. The bottom surface 122 of the first insulating layer 120 is opposite the bottom surface 114 of the recess. The bottom surface 122 of the first insulating layer 120 extends between the lateral surfaces 123 of the first insulating layer 120.

The first insulating layer 120 is silicon dioxide or other suitable insulating material.

The thickness of the first insulating layer 120 may be not uniform throughout. For example, the thickness of the first insulating layer 120 on the bottom surface 114 the recess is less than the thickness of the first insulating layer 120 on the sidewalls 115 of the substrate 110. In the alternative, the thickness of the first insulating layer 120 is substantially uniform throughout.

The second insulating layer 124 is on the first insulating layer 120. The second insulating layer 124 is in the recess of the substrate 110 and extends above the recess. The second insulating layer 124 contacts the first, second, and third surfaces 121, 123, 122 of the first insulating layer 120. The second insulating layer 124 extends past the first surface 112 of the substrate 110. The second insulating layer 124 covers the polysilicon source 130 and the gate 140. The second insulating layer 124 embeds and delimits the air gaps 160.

For example, the second insulating layer 124 is made of the same material as the first insulating layer 120, such as silicon dioxide.

The first insulating layer 120 and the second insulating layer 124 may be continuous and integral.

In the example of Figure 1, there is a recess or indentation in the second insulating layer 124 opposite the first end 131 of the polysilicon source 130. For example, the recess in the second insulating layer 124 is a central recess and does not extend past a top surface 142 of the gate 140.

The third insulating layer 125 is between the first insulating layer 120 and the second insulating layer 124. The third insulating layer 125 is between the gate 140 and the substrate 110.

In particular, the third insulating layer 125 covers a portion of the sidewalls 115 of the substrate 110 and contacts the body region 116 and the source region 118.

In addition, the third insulating layer 125 covers the top surface 112 of the substrate 110 so that a top surface of the third insulating layer 125 is above the top surface 142 of the gate 140.

In this embodiment, the third insulating layer 125 has an "L" or corner shape, meaning a first portion is transverse to a second portion. The third insulating layer 125 covers a corner of the substrate 110 but may have a different shape.

For example, the third insulating layer 125 is made of the same material as the first insulating layer 120, for example silicon dioxide.

Buried in the second insulating layer 124 is the polysilicon source or field plate 130. The polysilicon source 130 is here centrally located in the recess of the substrate 110. The top surface 131 of the polysilicon source 130 is transverse to lateral surfaces of the polysilicon source 130. The top surface 131 of the polysilicon source 130 is covered by the second insulating layer 124.

The top surface 131 of polysilicon source 130 does not extend past the first surface 121 of the first insulating layer 120.

The bottom surface 132 of the polysilicon source 130 is in the first insulating layer 120. The bottom surface 132 of the polysilicon source 130 is adjacent and opposite the bottom surface 114 of the recess. Said differently, the polysilicon source 130 does not extend through the first insulating layer 120 to contact the substrate 110. The first insulating layer 120 contacts portions of the lateral surfaces of the polysilicon source 130 adjacent to the bottom surface 132 of the polysilicon source 130.

The polysilicon source 130 extends in the vertical direction for a first dimension. The polysilicon source 130 extends in the horizontal direction for a second dimension. The second dimension of the polysilicon source 130 is here less than the first dimension of the polysilicon source 130 so that, in Figure 1, the polysilicon source 130 has an elongated shape in the first direction, but may have a different shape.

Spaced from the polysilicon source 130 is the at least one buried air gap or bubble 160. The air gap 160 is in and completely surrounded by the second insulating layer 124. Said differently, the second insulating layer 124 delimits the air gap 160 in the recess of the substrate 110.

The air gap 160 has a first or top end 161 opposite a second or bottom end 162. The first end 161 of the air gap 160 does not extend past the top surface 121 of the first insulating layer 120. The top end 161 of the air gap 160 is adjacent to the top surface 131 of the polysilicon source 130. The second end 162 of the air gap 160 is adjacent to the bottom surface 132 of the polysilicon source 130. The second end 162 of the air gap 160 is opposite and adjacent to the third surface 122 of the first insulating layer 120.

The air gap 160 extends in the vertical direction for a first dimension. Said differently, the first dimension is between the top and bottom ends 161, 162. The air gap 160 extends in the horizontal direction for a second dimension. The first dimension of the air gap 160 is greater than the second dimension of the air gap 160.

The first dimension of the air gap 160 is less than the first dimension of the polysilicon source 130; in particular, the polysilicon source 130 extends past the first and second ends 161, 162 of the air gap 160.

In this embodiment, there are a plurality of air gaps 160 of substantially similar size and shape. Ones of the air gaps 160 is between each respective sidewall 115 of the substate 110 and the polysilicon source 130. The polysilicon source 130 is for example spaced substantially equidistant from each of the air gaps 160. The polysilicon source 130 is separated from the air gaps 160 via the second insulating layer 124.

In particular, the air gap 160 is centrally located between the polysilicon source 130 and the first insulating layer 120 and is centrally located in the first direction between the top surface 121 of the first insulating layer 120 and the bottom surface 122 of the first insulating layer 120.

For example, the first dimension of the air gap 160 is more than half of the first dimension of the polysilicon source 130.

In general, the air gap 160 may have a size and shape similar to the polysilicon source 130 with a lesser vertical dimension.

For example, the second dimension of the air gap 160 ranges from 0.1 to 0.3 $\mu$m, in particular about 0.2 $\mu$m.

The at least one gate 140 is adjacent to the first end 161 of the air gap 160, on the top surface 121 of the first insulating layer 120. In particular, the gate 140 does not extend past the first end 161 of the air gap 160 and the top surface 142 of the gate 140 is substantially planar with the first surface 112 of the substrate 110.

The gate 140 does not entirely cover the top surface 121 of the first insulating layer 120. Instead, the third insulating layer 125 laterally separates the gate 140 and the substrate 110. The third insulating layer 125 contacts the top surface 121 of the first insulating layer 120 that is between the substrate 110 and the gate 140.

The top surface 142 of the gate 140 is recessed from the top surface of the third insulating layer 125. Said differently, the top surface 142 of the gate 140 is transverse to a surface of the third insulating layer 125.

The top surface 142 of the gate 140 may extend past the top surface 112 of the substrate 110, but may be coplanar with the top surface 112 or below (recessed) from the top surface 112 of the substrate 110.

A bottom surface 143 of the gate 140 is opposite the top surface 142 of the gate 140. The gate 140 has lateral surfaces transverse to the bottom and top surfaces 143, 142 of the gate 140. The lateral surfaces of the gate 140 are opposite each other. The bottom surface 143 of the gate 140 abuts or contacts the top surface 121 of the first insulating layer 120.

The gate 140 includes a gate protrusion 141 extending from the bottom surface 143 of the gate 140. The gate protrusion 141 extends on the lateral surface 123 of the first insulating layer 120.

The gate protrusion 141 has a bottom surface 144 transverse to the lateral surface 123 of the first insulating layer 120. Said differently, the gate protrusion bottom surface 144 is opposite the top surface 142 of the gate 140.

The second insulating layer 124 covers a lateral surface of the gate protrusion 141. The lateral surface of the gate protrusion 141 is transverse to the gate protrusion bottom surface 144.

The gate 140 is made of polysilicon or other suitable material; for example, the gate region 140 is made of the same material as the buried polysilicon region.

In the shown embodiment, the device 100 includes a plurality of gates 140 with some of the plurality of gates 140 facing each other and separated by the second insulating layer 124. The plurality of gates 140 are separated from a respective sidewall of the substrate 110 via the third insulating layer 125.

Body and source regions 116, 118 are in the substrate 110 at or near the first surface 112 of the substrate 110. Body and source regions 116, 118 are doped regions including n, p, or combination thereof.

In particular, here, the body region 116 does not extend past the top surface 121 of the first insulating layer 120.

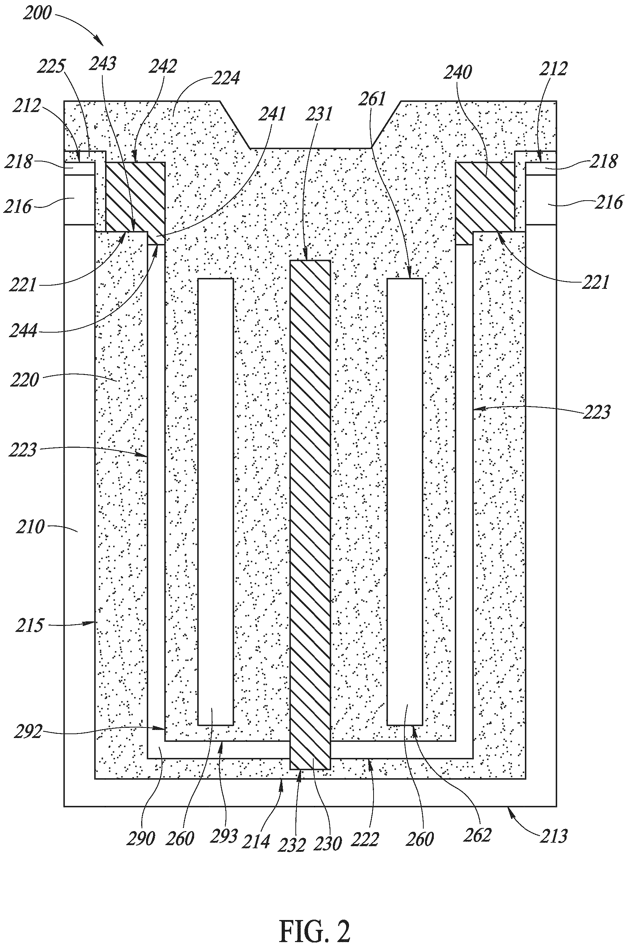

Figure 2 is a power MOSFET device 200, in the following also device 200, according to another embodiment. As in Figure 1, the device 200 includes a first insulating layer 220 on a substrate 210 that is recessed.

A nitride layer 290 is on the first insulating layer 220. A second insulating layer 224 is on the nitride layer 290.

In the second insulating layer 224 is a buried polysilicon source 230.

The device 200 includes at least one air gap 260 between the nitride layer 290 and the buried polysilicon source 230.

The device 200 includes body and source regions 216, 218 in the substrate 210 adjacent to a gate 240. The gate 240 is on the first insulating layer 220 and the nitride layer 290. A third insulating layer 225 separates the gate 240 and the substrate 210.

As in Figure 1, the substrate 210 has a recess in a first surface 212. The first surface 212 of the substrate 210 is opposite a second surface 213 of the substrate 210. Sidewalls 215 of the substrate 210 extend to a third or bottom surface 214 of the substrate 210.

As in Figure 1, the first insulating layer 220 is in the recess of the substrate 210 and entirely covers the bottom surface 214 of the substrate 210. The first insulating layer 220 is on a portion of the sidewalls 215 of the substrate 210.

The first insulating layer 220 has a first or top surface 221 transverse to the sidewalls 215 of the substrate 210.

A second surface or sidewall 223 of the first insulating layer 220 extends transverse to the first surface 221 of the first insulating layer 220.

A third surface 222 of the first insulating layer 220 extends transverse to the second surface 223 of the first insulating layer 220. The third surface 222 of the first insulating layer 220 is opposite the third surface 214 of the substrate 210 and extends between the sidewalls 215 of the substrate 210.

The nitride layer 290 has a top or first surface transverse to the second surface 223 of the first insulating layer 220. The top surface of the nitride layer 290 is in the recess of the substrate 210. In particular, the first surface of the nitride layer 290 is recessed from the first surface 221 of the first insulating layer 220.

A second surface or sidewall 292 of the nitride layer 290 extends transverse to the first surface of the nitride layer 290. A third surface 293 of the nitride layer 290 extends transverse to the second surface 292 of the nitride layer 290. The third surface 293 of the nitride layer 290 is opposite the third surface 222 of the first insulating layer 220.

Portions of the second surface 223 of the first insulating layer 220 are exposed (not covered by the nitride layer 290).

The top surface of the nitride layer 290 contacts or abuts the gate 240. A thickness of the nitride layer 290 is substantially equal to a thickness of a protrusion 241 of the gate 240.

The nitride layer 290 may have a thickness less than a thickness of the first insulating layer 220. In the alternative, the nitride layer 290 has a thickness substantially equal to a thickness of the first insulating layer 220.

For example, the nitride layer 290 has a thickness ranging from 0.1 to 0.5 $\mu$m, in particular about 0.35 $\mu$m.

As in Figure 1, the gate 240 includes a top surface 242 opposite a bottom surface 243. Lateral surfaces of the gate 240 are transverse to the top and bottom surfaces 242, 243 of the gate 240. The gate protrusion 241 extends from the bottom surface 243 of the gate 240. The gate protrusion 241 has a bottom surface 244 opposite the top surface 242 of the gate 240.

The bottom surface 244 of the gate protrusion 241 contacts the top surface of the nitride layer 290. The bottom surface 244 of the gate protrusion 241 is transverse to the second surface 223 of the first insulating layer 220.

The bottom surface 244 of the gate protrusion 241 is adjacent to the top surface 221 of the first insulating layer 220.

As in Figure 1, the device 200 includes the polysilicon source 230, which is buried. The polysilicon source 230 has a first or top surface 231 opposite a second or bottom surface 232. The top surface 231 of the polysilicon source 230 is completely covered by the second insulating layer 224. The bottom surface 232 of the polysilicon source 230 is adjacent to the third surface 214 of the substrate 210.

The polysilicon source 230 extends through the nitride layer 290. Said differently, portions of the nitride layer 290 contact portions of the polysilicon source 230.

The bottom surface 232 of the polysilicon source 230 is in and completely covered by the first insulating layer 220. Said differently, portions of the first insulating layer 220 contact portions of the polysilicon source 230.

In Figure 2, the polysilicon source 230 extends about midway in the first insulating layer 220.

In this Figure, the polysilicon source 230 separates the nitride layer 290 into two portions, each portion coating a respective sidewall 215 of the substrate 210. The two portions of the nitride layer 290 have the substantially same size and shape. for example, the two portions of the nitride layer 290 are mirror images or reflections of each other.

The third insulating layer 225 has similar features as described in Figure 1.

As in Figure 1, the second insulating layer 224 includes the at least one air gap 260. The second insulating layer 224 completely surrounds and delimits the air gap 260.

The air gap 260 is in the recess of the substrate 210 and adjacent to the polysilicon source 230.

The air gap 260 has a first end 261 opposite a second end 262. The first end 261 of the air gap 260 does not extend past the top surface 231 of the polysilicon source 230. The first end 231 of the air gap 260 does not extend past the top surface of the nitride layer 290. The first end 261 of the air gap 260 is adjacent to the top surface 231 of the polysilicon source 230. The first end 261 of the air gap 260 is spaced from and adjacent to the bottom surface 244 of the gate protrusion 241.

The air gap 260 is between the second surface 292 of the nitride layer 290 and the polysilicon source 230. The second end 262 of the air gap 260 is spaced from the third surface 293 of the nitride layer 290 via the second insulating layer 224. The second end 262 of the air gap 260 does not contact the nitride layer 290.

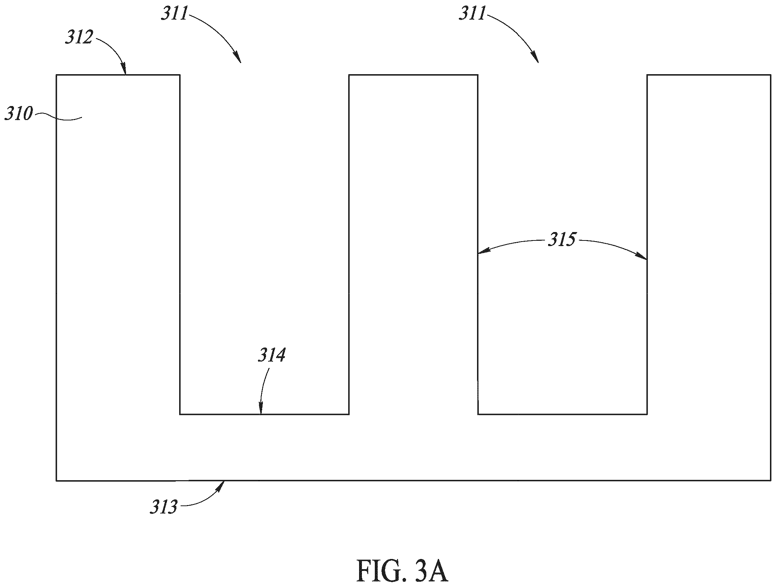

Figures 3A-3R are steps of a method of manufacturing the device 200 of Figure 2. Chemical Vapor Deposition (CVD) can be used to easily coat sidewalls, then pinch off the middle, to form a closed air gap in a single step.

Figure 3A is a substrate 310 having a first or top surface 312 opposite a second or bottom surface 313. The substrate 310 has a plurality of recesses or trenches 311 of substantially similar size and shape in the first surface 312 of the substrate 310. The recesses 311 are spaced from each other. Each recess 311 has sidewalls 315 extending from the first surface 312 to a respective bottom surface 314 of the recess 311. The bottom surface 314 of the recess 311 is opposite the second surface 313 of the substrate 310.

The substrate 310 is silicon or other suitable material.

The bottom surface 314 of the recess 311 may extend in the second or horizontal direction for a range of 1 to 2 $\mu$m, for example about 1.6$\mu$m. The sidewalls 315 of the recess 310 extend in the vertical or first direction for a range of 4 to 6 $\mu$m, for example for about 5$\mu$m.

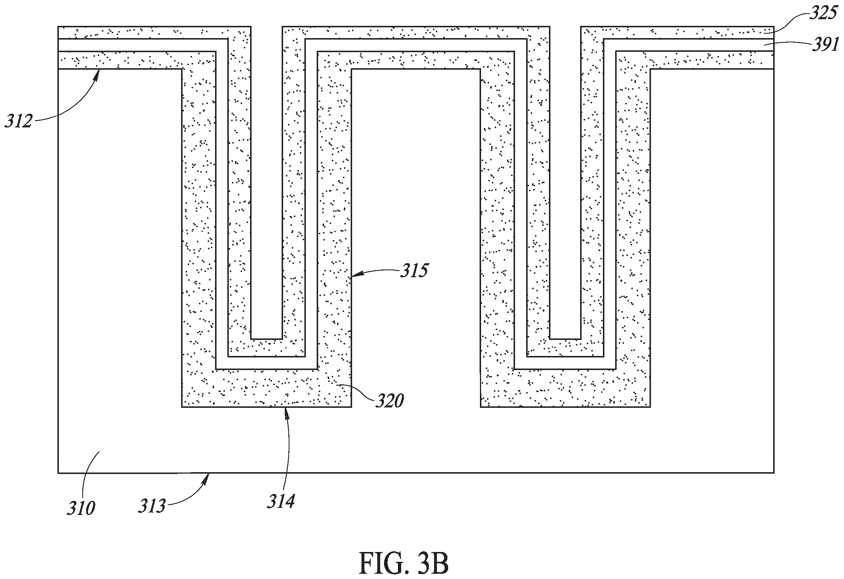

Next, in Figure 3B, a first insulating layer 320, a nitride layer 391, and a second insulating layer 325 are formed on the substrate 310 and in the recesses 311. The nitride layer 391 is between the first insulating layer 320 and the second insulating layer 325. The first insulating layer 320 covers the first surface 312 of the substrate 310, the sidewalls 315 and the bottom surfaces 314 of the recesses 311. The first insulating layer 320 has a first thickness, for example of 2kÅ (200 nm).

The nitride layer 391 has a second thickness less than the first thickness of the first insulating layer 320. The nitride layer 391 covers a top surface of the first insulating layer 320. For example, the nitride layer 391 has a thickness of 400 Å (40 nm). The nitride layer 391 is silicon nitride or other suitable material.

The second insulating layer 325 is a sacrificial oxide layer.

The second insulating layer 325 has a third thickness less than the first thickness of the first insulating layer 320. The first and second insulating layers 320, 325 may be of the same material. The second insulating layer 325 entirely covers a top surface of the nitride layer 391. For example, the second insulating layer 325 has a thickness of 4kÅ.(0.4 $\mu$m) or 0.35 $\mu$m.

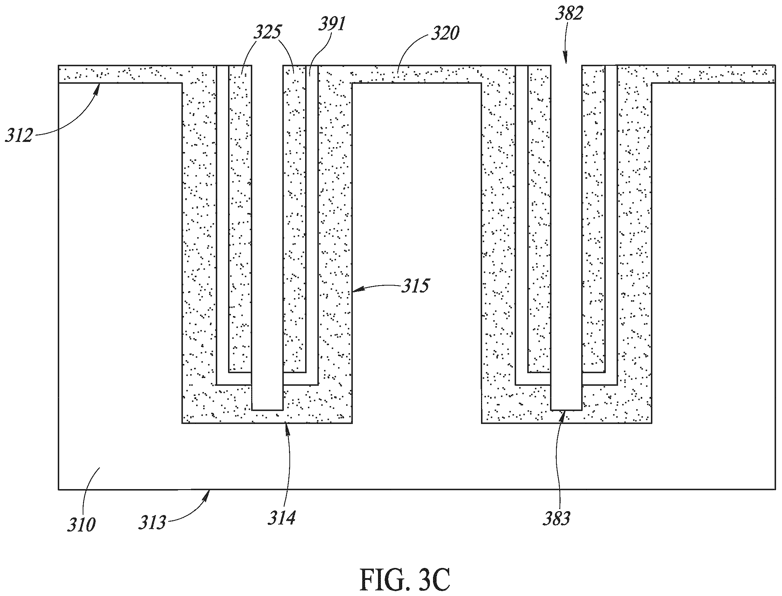

Next, in Figure 3C, portions of the nitride layer 391, first insulating layer 320, and second insulating layer 325 are removed. Recesses 382 are formed that are delimited by the first and second insulating layers 320, 325 and the nitride layer 391.

Surfaces of the first and second insulating layers 320, 325 and the nitride layer 391 that delimit the recesses 382 are coplanar.

Removal exposes a top surface of the first insulating layer 320, a top surface of the nitride layer 391, and a top surface of the second insulating layer 325. The top surfaces of the first insulating layer 320, nitride layer 391, and second insulating layer 325 are coplanar. A bottom surface of the recess 383 is delimited by the first insulating layer 320. The bottom surface of the recess 383 is opposite the bottom surface of the substrate recess 314.

Removal may be carried out via nitride dry etch, for example via etching in the vertical direction.

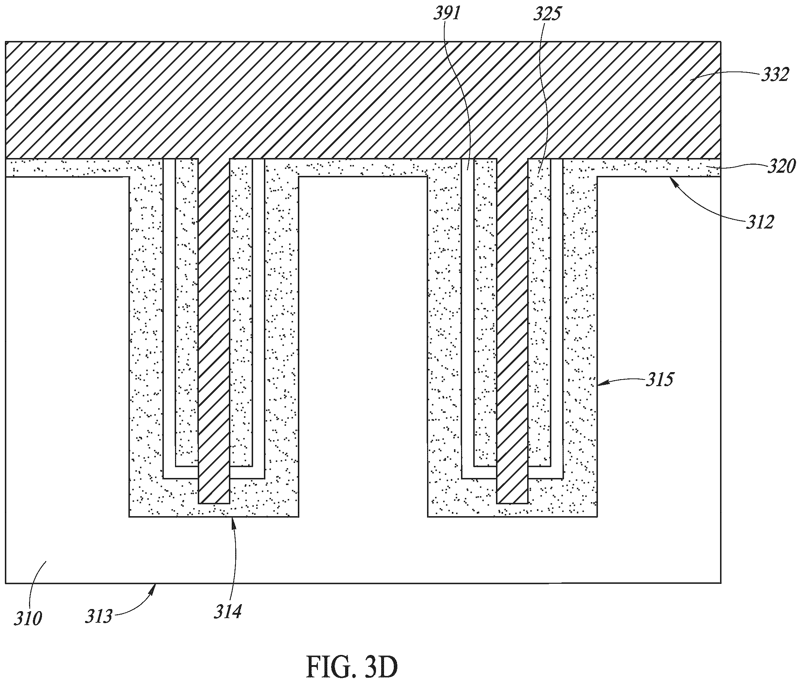

Next, in Figure 3D, a polysilicon material 332 is deposited on the substrate 310. The polysilicon material 332 entirely fills the recesses 382.

The polysilicon material 332 covers the top surfaces of the first and second insulating layer 320, 325 and the top surfaces of the nitride layer 391.

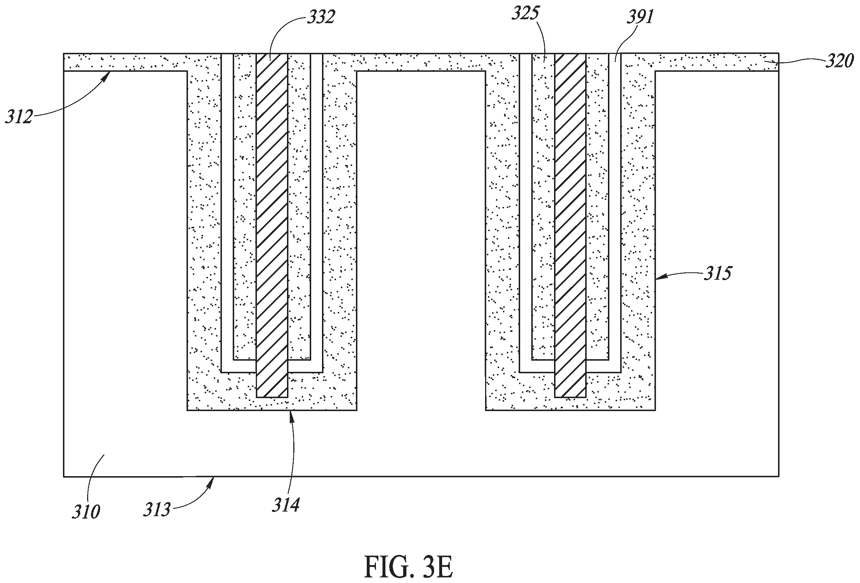

Next, in Figure 3E, portions of the deposited polysilicon material 332 are removed. A top surface of the polysilicon material 332 is exposed and is coplanar with the top surfaces of the first and second insulating layers 320, 325 and the nitride layer 391.

The polysilicon material 332 may extend past the first surface 312 of the substrate 310. In the alternative, the polysilicon material 332 does not extend past the first surface 312 of the substrate 310. Said differently, the top surface of the polysilicon material 332 is coplanar with the first surface 312 of the substrate 310.

Removal may be carried out via chemical mechanical planarization or polishing.

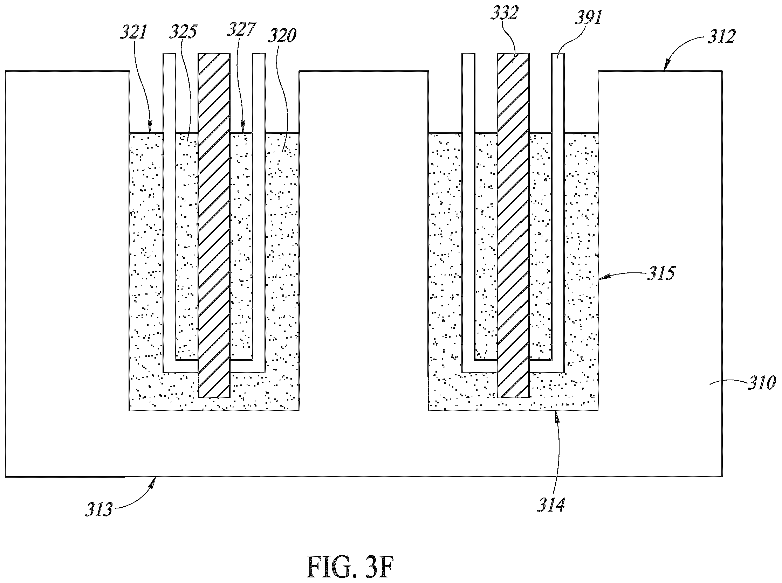

Next, portions of the first and second insulating layers 320, 325 are removed in Figure 3F, for example via wet etch. The removal is carried out at the top surfaces of the first and second insulating layers 320, 325 and exposes a plurality of recessed top surfaces 321, 327 of the first and second insulating layers 320, 325.

The recessed top surfaces 321, 327 of the first and second insulating layers 320, 325 are recessed from the first surface 312 of the substrate 310. The polysilicon material 332 and the nitride layer 391 extend past the recessed top surfaces 321, 327 of the first and second insulating layers 320, 325.

Top surfaces of the polysilicon material 332 and the nitride layers 391 are coplanar. The polysilicon material 332 and the nitride layers 391 extend past the top surface of the substrate 312.

However, the polysilicon material 332 and the nitride layers 391 may not extend past the top surface of the substrate 312.

For example, the removal is carried out.

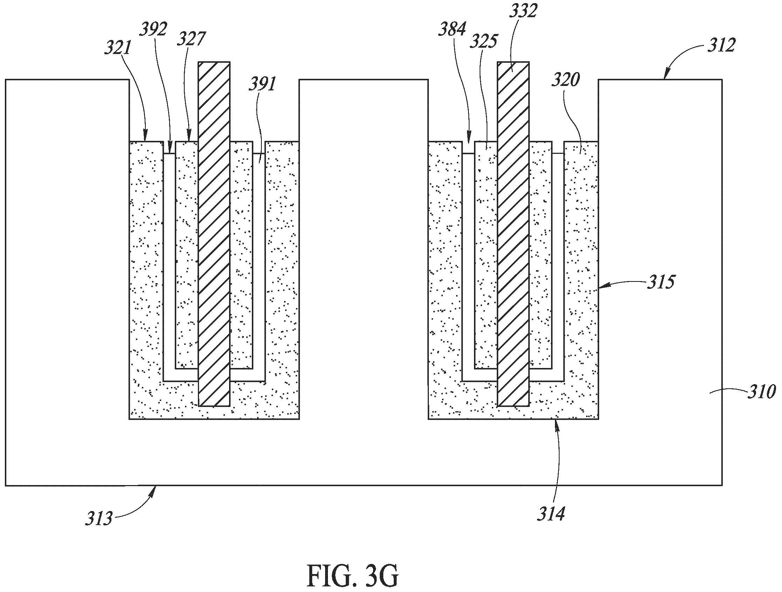

Next, in Figure 3G, portions of the nitride layers 391 are removed. The removed portions are from the top surface of the nitride layer 391 and exposes recessed top surfaces 392 of the nitride layers 391. Removal forms a plurality of recesses 384 delimited by the top surfaces 392 of the nitride layers 391 and lateral surfaces of the first and second insulating layers 320, 325. The recessed top surfaces 392 of the nitride layers 391 are recessed from the top surfaces 321, 327 of the first and second insulating layers 320, 325. The recesses 384 are between the first and second insulating layers 320, 325.

For example, the removal is carried out via wet etch.

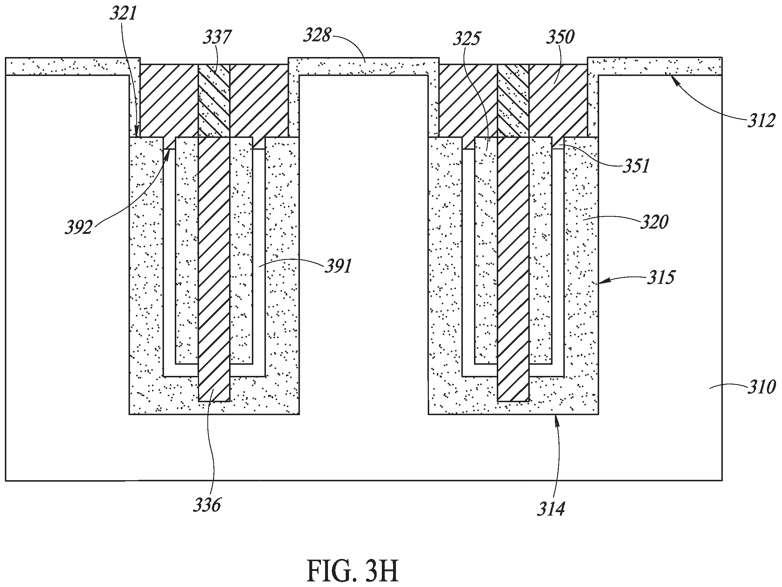

Next, in Figure 3H, a third insulating layer 328 is formed on the substrate 310. The third insulating layer 328 covers the top surface of the substrate 312 and extends along the sidewalls 315 of the substrate 310. The third insulating layer 328 contacts the top surfaces 321 of the first insulating layer 320.

An exposed portion of the polysilicon material 332 of Figure 3G is oxidized, forming an oxidized portion 337 that extends past the top surfaces 327 of the second insulating layer 325, thereby defining a first polysilicon source 336 including the oxidized portion 337.

A second polysilicon material is deposited on the first and insulating layers 320, 325. The second polysilicon material fills the recesses 384 of the nitride layer 391 (Figure 3G) and contacts the recessed top surfaces 392 of the nitride layers 391. Top and lateral surfaces of the first and second insulating layers 320, 325 contact the second polysilicon material. The second polysilicon material contacts the first polysilicon source 336 and the third insulating layer 328.

The gates 350 are formed by removing portions of the second polysilicon material. Removal exposes top surfaces of the gates 350 that are coplanar with a top surface of the oxidized portion 337 of the first polysilicon source 336.

The top surface of the gates 350 are recessed from the third insulating layer 328. Said differently, the third insulating layer 328 extends past the top surface of the gates 350. The gates 350 include a gate protrusion 351 that contacts the nitride layer 391.

Removal may be carried out by etching, chemical mechanical planarization, or a combination of both.

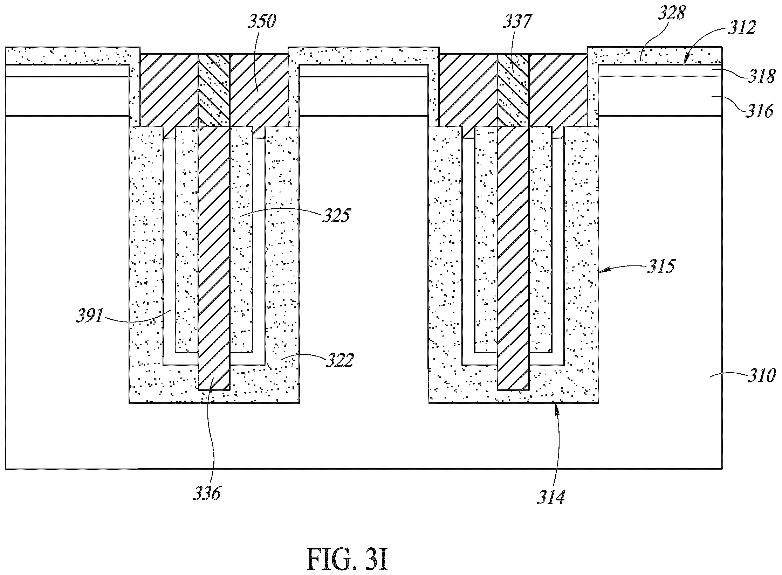

Next, in Figure 3I, source and body regions 318, 316 are formed in the substrate 310. For example, forming is carried out via implantation or doping. Forming the source and body regions 318, 316 may be carried out through the third insulating layer 328.

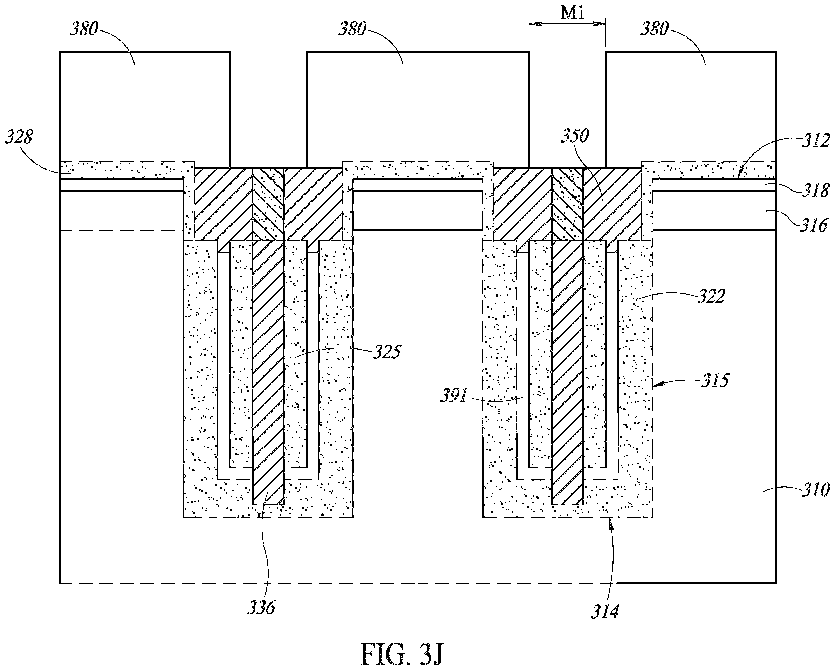

Next, in Figure 3J, a mask 380 is formed on the substrate 310. The mask 380 is formed in a manner to have a plurality of openings on the first polysilicon source 336 so that portions of the gates 350 are exposed . The openings have a dimension M1 in the second (horizontal) direction between portions of the mask 380. For example, the dimension M1 is 1.2μm.

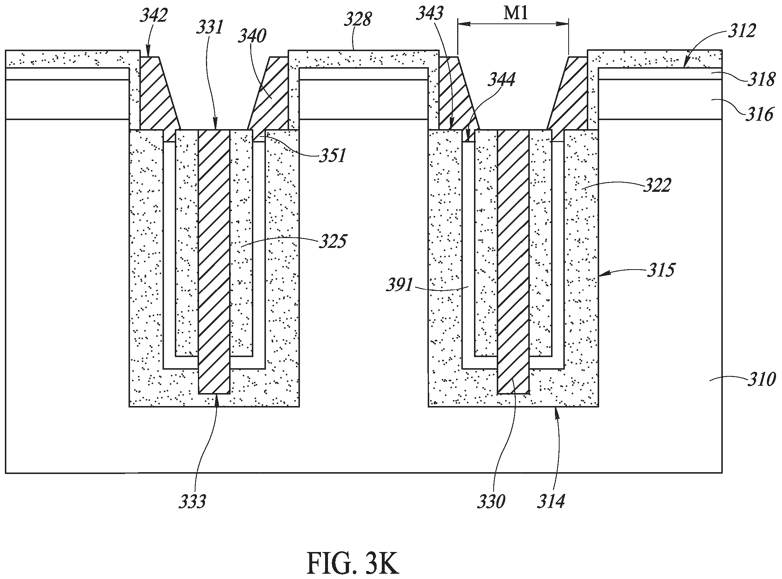

Next, in Figure 3K, sloped gates 340 are formed. Forming is carried out by etching the first polysilicon source 336 and the gates 350. The mask 380, e.g., of photoresist, is used to pattern the gates 350.

The sloped gates 340 have a top surface 342 transverse to a lateral surface of the third insulating layer 328.

Exposed sloped surfaces extend from the top surface 342 of the sloped gates 340 to the second insulating layer 325. A bottom surface 343 of the sloped gate 340 is opposite the top surface 342. The gate protrusion 351 of the sloped gate 340 extends from the bottom surface 343. The gate protrusion 351 of the sloped gate 340 has a bottom surface 344 that contacts the nitride layer 391.

Etching the first polysilicon source 336 thereby forms a second polysilicon source 330.

The second polysilicon source 330 has a top surface 331 coplanar with top surfaces of the second insulating layers 325. A bottom surface 333 of the second polysilicon source 330 is opposite the top surface 331. The bottom surface 333 is in the first insulating layer 320.

Forming of the sloped gates 340 may be carried out via wet etching. After etching, the mask 380 is removed.

The second insulating layer 325 may have a thickness in the second (horizontal) direction of 0.4 μm. The first insulating layer 320 may have a thickness in the second direction of 0.2 μm. The dimension in the second direction between the polysilicon source 330 and the substrate 310 may be about 0.6 μm. Said differently, the thickness of the nitride layer 391 and first and second insulating layers 320, 325 may be 0.6 μm (the thickness of the nitride layer 391, a few nanometers, may be neglected). The second polysilicon source 330 may have a thickness in the second direction of 0.3 μm.

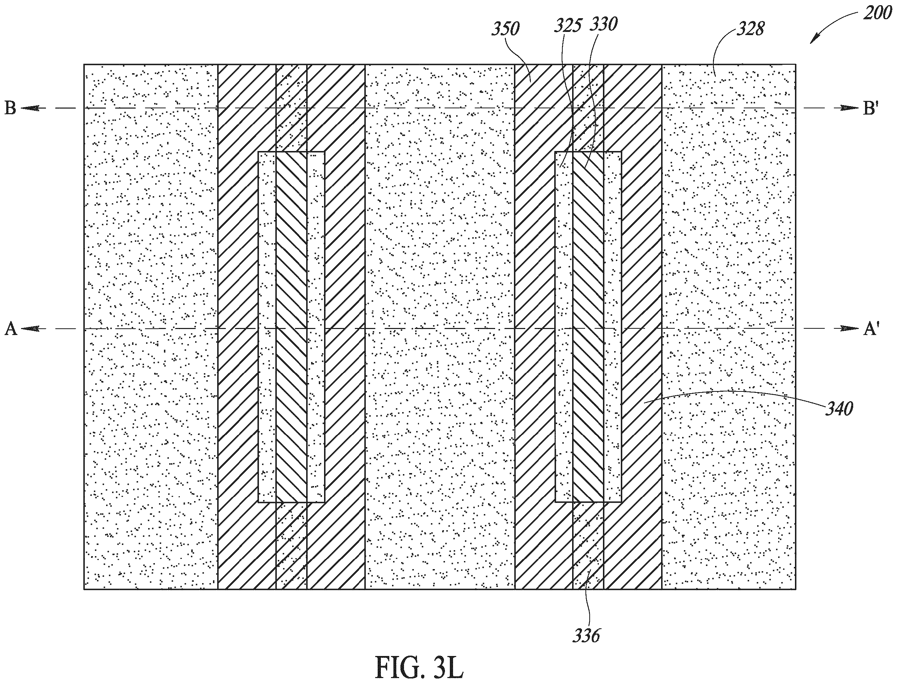

Next, the second insulating layer 325 is removed, for example via wet etch, as shown in Figure 3L-3N.

Figure 3L is a top view of the device 200. Cross-section line A-A' is through the first portion of the device 200 having the sloped gates 340. Cross-section line B-B' is through a second portion of the device having the gates 350.

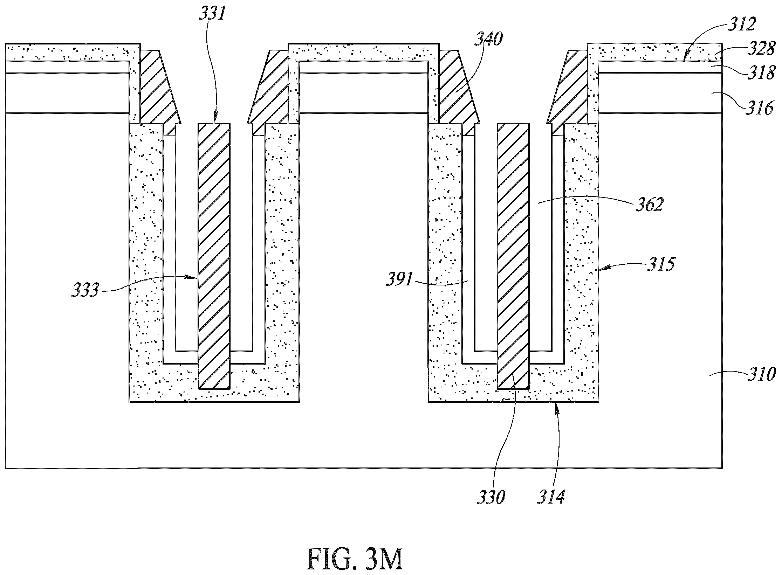

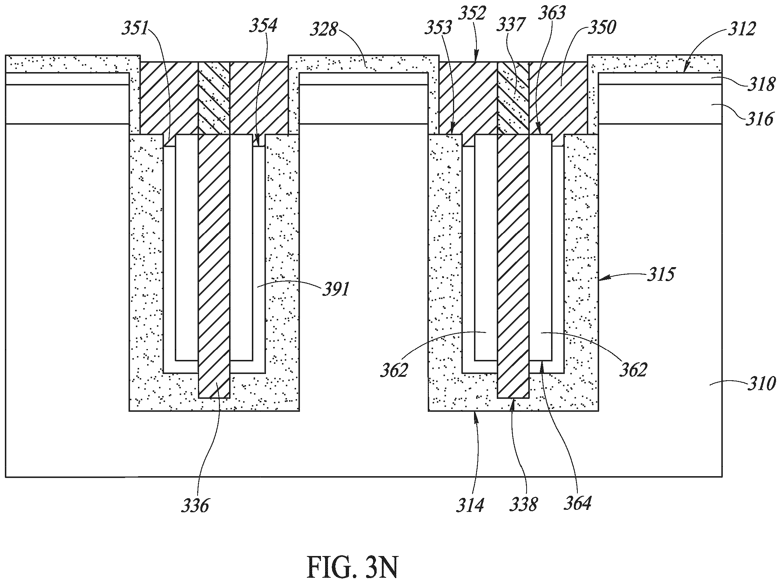

Figure 3M is a cross-section of line A-A' of Figure 3L and Figure 3N is a cross-section of line B-B' of Figure 3L. In Figures 3M and 3N, a cavities 362 are formed by the removal of the second insulating layer 325.

In Figure 3N, the cavities 362 are buried below the gates 350. The cavities 362 are delimited by the gates 350, including the gate protrusions 351, the nitride layer 391, and the first polysilicon source 336. A top surface 352 of the gates 350 is opposite a bottom surface 353 of the gates 350. Portions of the bottom surfaces 353 of the gates 350 that are between the first polysilicon source 336 and the gate protrusions 351 delimit the cavity 362.

In Figure 3M, the removal of the second insulating layer 325 exposes lateral surfaces 333 of the polysilicon source 330 and surfaces of the nitride layer 391. Surfaces of the sloped gates 340 are also exposed, including surfaces of the gate protrusions 351.

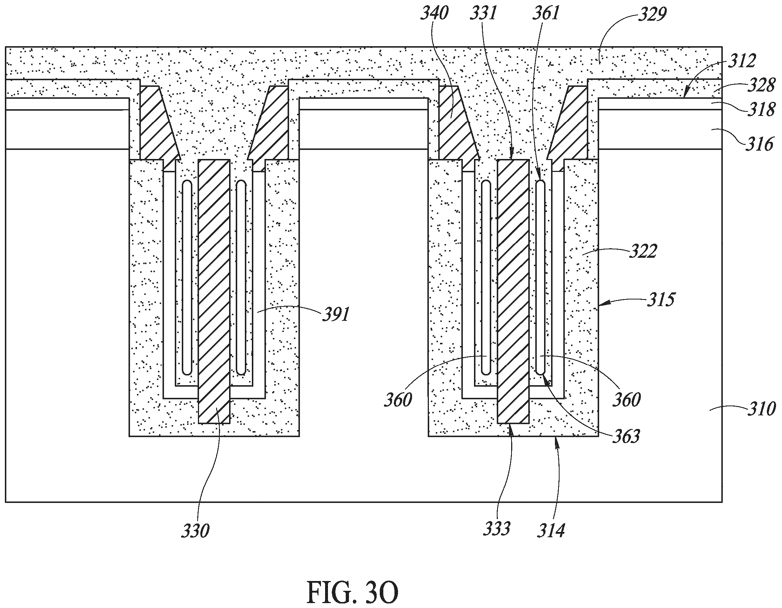

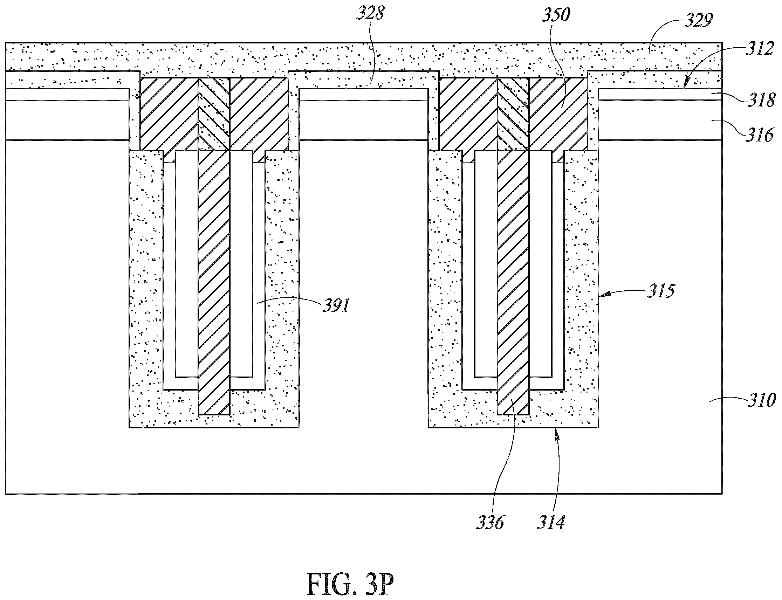

Next, Figures 3O and 3P, a fourth insulating layer 329 is formed.

In this step, Figure 3O, an air gap 360 is formed. The air gap 360 is buried in the fourth insulating layer 329. The air gap 360 has a first end 361 opposite a second end 363. The first end of the air gap 361 does not extend past the top surface 321 of the first insulating layer 320.

For example, the fourth insulating layer 329 is formed via non-conformal chemical vapor deposition of oxide, which forms the air gap 360. A high aspect ratio (>10) results in air-gap formation due to poor filling of non-conformal CVD process.

In Figure 3P, the fourth insulating layer 329 extends over the first surface 312 of the substrate 310 covering the top surface of the gate 350 and third insulating layer 328.

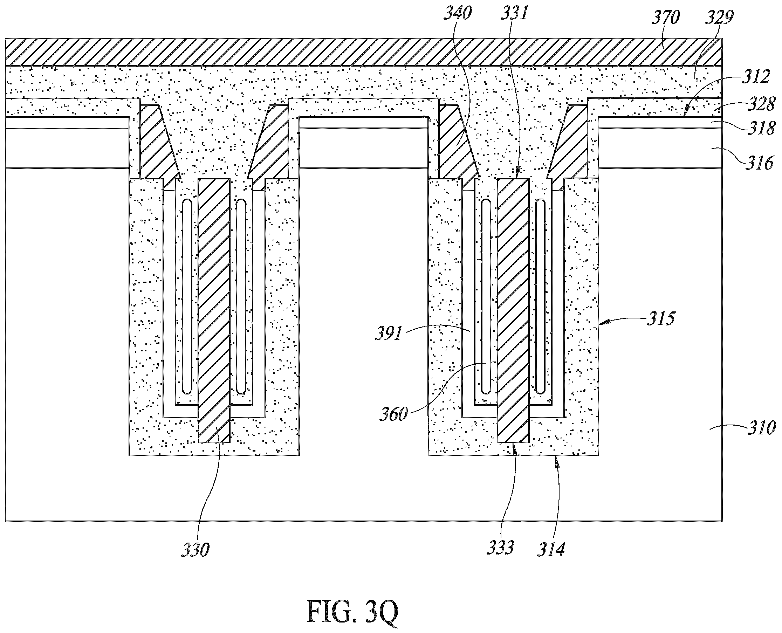

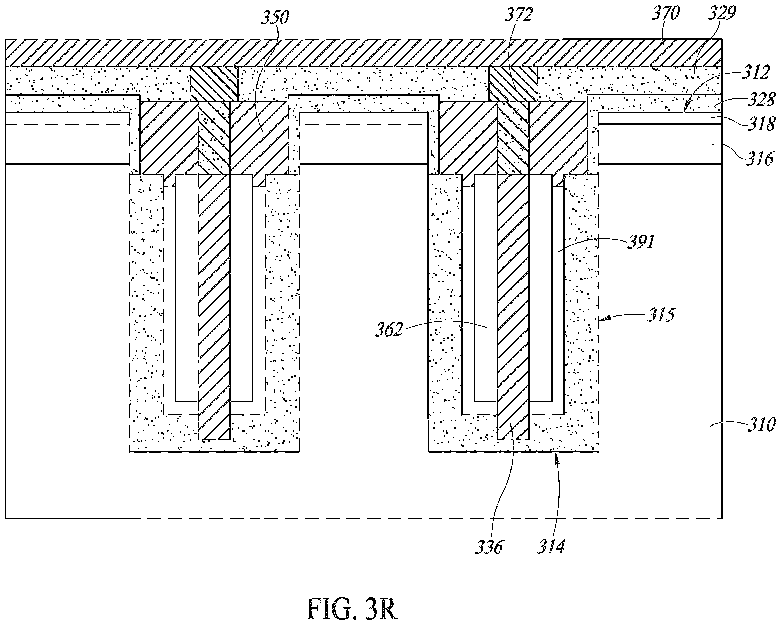

Next, Figure 3Q and Figure 3R, contacts 372 are formed in the insulating layer 329 and a conductive layer 370 is formed on the insulating layer 329.

In Figure 3Q and Figure 3R, the conductive layer 370 is formed entirely on the insulating layer 329.

For example, the conductive layer 370 is aluminum or other suitable material and may be formed via plasma metal deposition and planarization.

Figure 3R shows the contacts 372. The contacts 372 are between the conductive layer 370 and the gate 350. The contacts 372 contact the first polysilicon source 336.

For example, the contacts 372 are made of tungsten or other suitable conductive material.

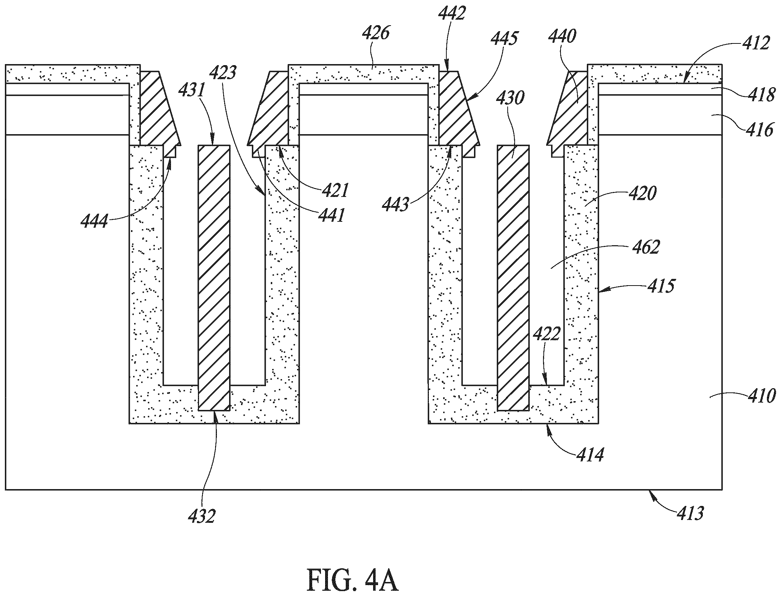

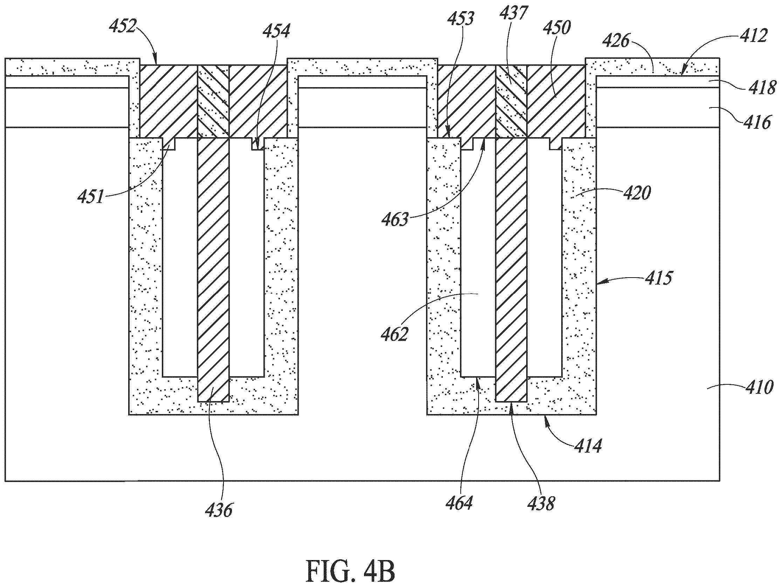

Figures 4A-4F are steps of a method of manufacturing the device 100 of Figure 1. Prior to Figures 4A and 4B, similar steps as those described for Figures 3A-3L are carried out.

Not shown, a substrate 410 has a plurality of recesses in a first surface 412 of the substrate 410, as in Figure 3A. A second surface 413 of the substrate 410 is opposite the first surface 412.

Next, not shown, a first insulating layer 420, a nitride layer, and a second insulating layer are formed on the substrate 410, as in Figure 3B.

Next, not shown, the first insulating layer 420, the nitride layer, and the second insulating layer are etched, as in Figure 3C, to form a recess.

Next, not shown, a polysilicon material is deposited, as in Figure 3D. The polysilicon material filling the recesses.

Next, not shown, a step of planarization is carried out thereby making top surfaces of the first insulating layer 420, the nitride layer, the second insulating layer, the polysilicon material, and the substrate 410 coplanar, as in Figure 3E.

Next, not shown, the first insulating layer 420 and the second insulating layer are etched, as in Figure 3F. Top surfaces of the first insulating layer 420 and the second insulating layer are recessed from the top surface of the polysilicon material.

Next, not shown, portions of the nitride layers 391 may be removed, as in Figure 3G.

Next, a third insulating layer 426 is formed on the substrate 410, as in Figure 3H. A portion of the polysilicon material that is exposed is oxidized. The gates 350 with the protrusions 451 are formed.

Next, source and body regions 418, 416 are formed in the substrate 410, as in Figure 3I. Forming may be done via doping.

Next, not shown, a mask is formed on the substrate 410, as in Figure 3J.

Next, the gates 440 are formed, as in Figure 3K.

Next, in Figures 4A and 4B, the nitride layer and second insulating layer are removed. The nitride layer is also removed in the same manner as the second insulating layer is removed.

Figure 4A is a cross-section from line A-A' and Figure 4B is a cross-section from line B-B', as in Figure 3L. Figure 4A is of a portion of the device 200 having the sloped gates 440 and Figure 4B is a portion of the device 200 having the non-etched gates 450.

In Figure 4A, the second insulating layer is removed, as in Figure 3M. In this step, exposed (oxidated) surfaces of the polysilicon material are also removed, forming a polysilicon source 430. Not exposed portions of the polysilicon material are not removed, figure 4B, forming an oxidized-top polysilicon source 436.

Surfaces of the gates 440 are exposed.

Surfaces 422, 423 of the first insulating layer 420 are also exposed. Recessed surface 422 of the first insulating layer 420 is opposite recessed surface 414 of the substrate 410. Lateral surfaces 423 of the first insulating layer 420 delimit an opening between the polysilicon source 430 and the first insulating layer 420.

Removal of the second insulating layer and of the nitride layer forms cavities 462.

In Figure 4B, the cavities 462 are between the first insulating layer 420 and the oxidized-top polysilicon source 436. The cavities 462 are between the gates 450 and the first insulating layer 420. Said differently, the oxidized-top polysilicon source 436, the first insulating layer 420, and the gates 450 delimit the cavities 462.

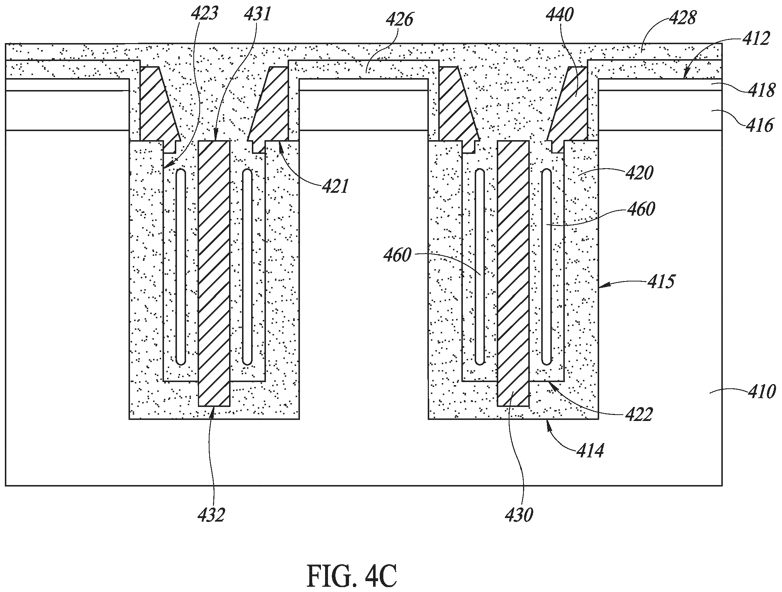

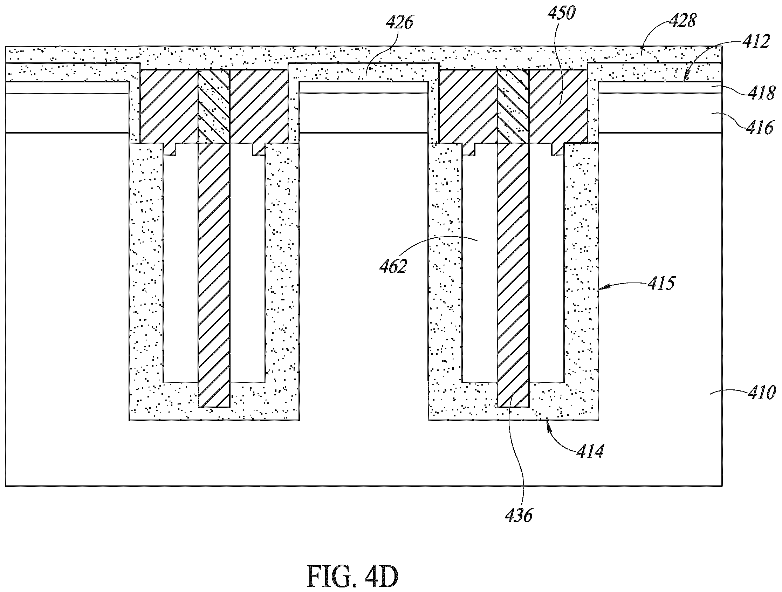

Next, a fourth insulating layer 428 is formed in Figures 4C and 4D.

In Figure 4C, the fourth insulating layer 428 fills the cavities 462 between the polysilicon source 430 and the first insulating layer 420. The fourth insulating layer 428 covers the third insulating layer 426 and the gates 440.

Forming the fourth insulating layer 428 forms the buried air gaps 460 in the cavities 462. The fourth insulating layer 428 contacts the recessed surface 422 of the first insulating layer 420. The first, third, and fourth insulating layers 420, 426, 428 may become integral and continuous.

For example, the buried air gaps 460 are formed via non-conformal deposition of the fourth insulating layer 428.

In Figure 4D, the fourth insulating layer 428 is on the gates 450 and the third insulating layer 426. Therefore, here the cavities 462 are not filled by the fourth insulating layer 428.

The fourth insulating layer 428 contacts a top surface of the oxidized-top polysilicon source 436.

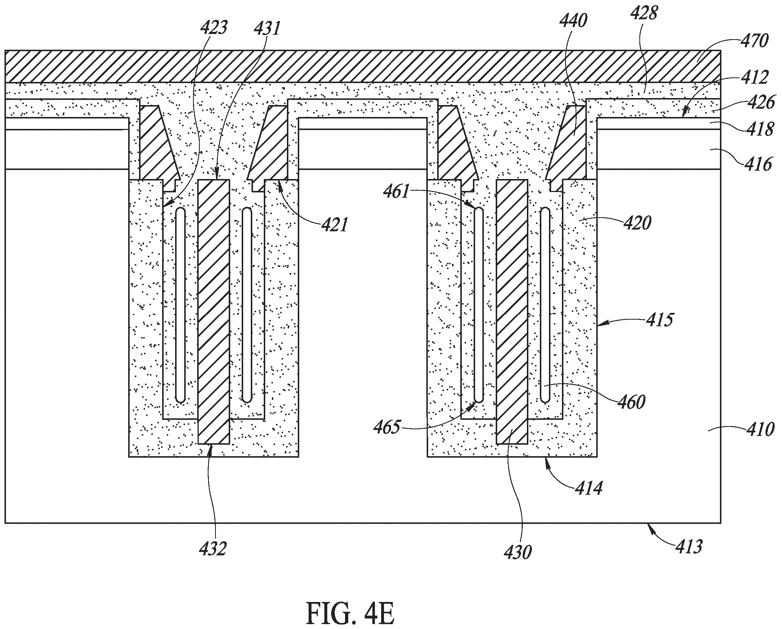

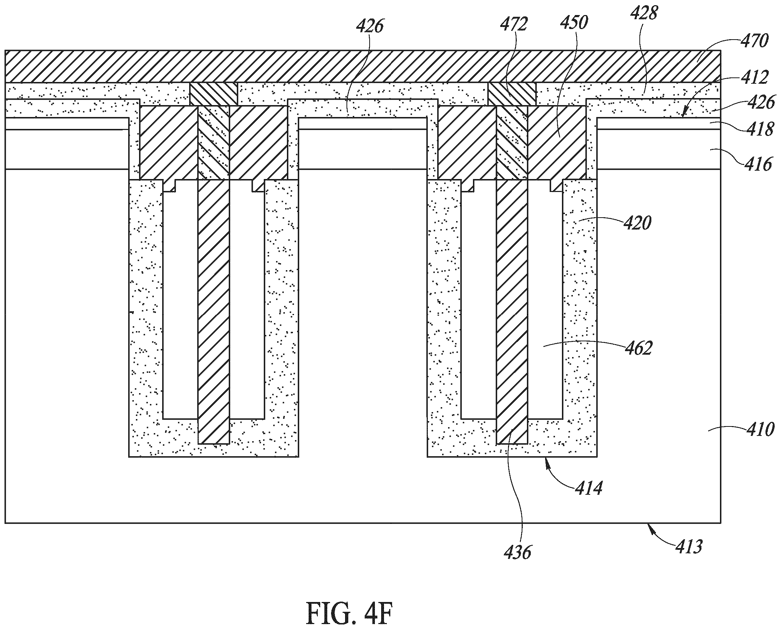

Next, Figures 4E and 4F, contacts 472 and a conductive layer 470 are formed.

Conductive layer 470 is formed on the fourth insulating layer 428.

In Figure 4E, the conductive layer 470 entirely covers the fourth insulating layer 428, as in Figure 3Q.

In Figure 4F, contacts 472 are formed between the conductive layer 470 and the gates 450, as in Figure 3R.

Finally, it is clear that modifications and variations may be made to the power module and to the assembling method described and illustrated herein without thereby departing from the scope of the present invention, as defined in the attached claims.

Summarizing, the present disclosure regards a device comprising:

a power MOSFET, including:

a substrate, including:

a recess in a first surface of the substrate, the first surface extending in a first direction, the recess having sidewalls extending in a second direction transverse the first direction, the recess including a second surface extending in the first direction between the sidewalls;

an insulating layer on the first surface of the substrate and in the recess;

a first polysilicon region in the insulating layer, the first polysilicon region extending in the second direction for a first dimension; and

an air gap in the insulating layer between the first polysilicon region and the substrate, the air gap extending in the second direction for a second dimension being less than the first dimension.

The air gap may extend in the first direction for a third dimension being less than the second dimension.

The first polysilicon region may extend in the first direction for a third dimension being less than the first dimension.

The first polysilicon region may have a first end spaced from the second surface of the recess for a third dimension.

The air gap may have a first end spaced from the second surface of the recess for a fourth dimension, the third dimension being less than the fourth dimension.

The device may further comprise a field plate oxide layer in the recess and between the substrate and the insulating layer, the field plate oxide layer having a first surface extending in the first direction adjacent the first surface of the substrate.

The first polysilicon region may extend in the field plate oxide layer.

The device may further comprise a gate polysilicon region on the first surface of field plate oxide layer, the gate polysilicon region including a protrusion extending into the insulating layer.

The device may further comprise a source region and a body region, the source region being on the body region, the body region contacting the first surface of the substrate, a portion of the insulating layer between the gate polysilicon region and the source and body regions.

The device may further comprise a nitride layer between the field player oxide layer and the insulating layer, the first polysilicon region extending through the nitride layer.

The air gap may be surrounded by the insulating layer.

In addition, the device may be summarized as comprising:

a power MOSFET including:

a recessed substrate;
an insulating layer on the recessed substrate;
a first polysilicon region in the insulating layer;
a first air gap in the insulating layer; and
a second air gap in the insulating layer, the first polysilicon region between the first and second air gaps.

The first and second air gaps may be each equally spaced from the first polysilicon region in a first direction.

The first and second air gaps may have substantially the same shape and dimensions.

The first and second air gaps may extend in a second direction transverse the first direction for a first dimension, the first polysilicon region extends in the second direction for a second dimension greater than the first dimension, the first polysilicon region extending through the insulating layer.

A method may be further summarized as comprising:

forming a power MOSFET device by:

forming a first insulating layer on a substrate including a recess, the first insulating layer covering a first surface of the substrate, recess sidewalls, and a second surface of the recess extending between the sidewalls;

forming a first polysilicon region in the insulating layer; and

forming an air gap in the insulating layer on the substrate.

Forming the first polysilicon region may include depositing a first polysilicon material on the first insulating layer and in the recess.

Forming the air gap may include etching the insulating layer to expose a surface of the insulating layer that is recessed from the first surface of the substrate.

The method may further comprise forming a gate region by depositing a second polysilicon material on the insulating layer and etching the second polysilicon material.

The method may further comprise forming source and drain regions on the substrate.

## Claims

1. A power MOSFET device, comprising:

   a substrate (110; 210; 310; 410), including:
   a recess in a first surface (112; 212; 312; 412) of the substrate, the first surface extending in a first direction, the recess having sidewalls (115; 215; 315) extending in a second direction transverse the first direction, the recess including a second surface (114; 214; 314; 414) extending in the first direction between the sidewalls;
   an insulating layer (124, 125; 224, 225; 329, 328; 428, 426) on the first surface of the substrate and in the recess;
   a polysilicon region (130; 230; 330; 430) in the insulating layer, the polysilicon region extending in the second direction; and
   an air gap (160; 260; 360; 430) in the insulating layer between the polysilicon region and the substrate, the air gap extending in the second direction.

2. The device of claim 1, wherein the polysilicon region (130; 230; 330; 430) extends in the second direction for a first dimension; and the air gap (160; 260; 360; 430) extends in the insulating layer (124, 125; 224, 225; 329, 328; 428, 426) in the second direction for a second dimension less than the first dimension.

3. The device of the preceding claim, wherein the air gap (160; 260; 360; 430) extends in the first direction for a third dimension that is less than the second dimension.

4. The device of any of the preceding claims, wherein the polysilicon region (130; 230; 330; 430) extends in the first direction for a third dimension that is less than the first dimension.

5. The device of any of the preceding claims, wherein polysilicon region (130; 230; 430; 430) has a first end (132; 232) spaced from the second surface (114; 214; 314) of the recess.

6. The device of any of the preceding claims, comprising a field plate oxide layer (120; 220; 320; 420) in the recess and between the substrate (110; 210; 310; 410) and the insulating layer (124, 125; 224, 225; 329, 328; 428, 426), the field plate oxide layer having a first surface (121; 212; 312; 412) extending in the first direction adjacent the first surface of the substrate.

7. The device of the preceding claim, wherein the first polysilicon region (130; 230; 430; 430) extends in the field plate oxide layer (120; 220; 320; 420).

8. The device of claim 6 or 7, comprising a gate region (140; 240; 340; 440) on the first surface (121; 221; 321) of field plate oxide layer (120; 220; 320; 420), the gate region including a protrusion (141; 241; 351; 451) extending into the insulating layer (124, 125; 224, 225; 329, 328; 428, 426).

9. The device of the preceding claim, comprising a source region (118; 218; 318; 418) and a body region (116; 216; 316; 416), the source region being on the body region, the source region contacting the first surface (112; 212; 312; 412) of the substrate (110; 210; 310; 410), a portion of the insulating layer (124, 125; 224, 225; 329, 328; 428, 426) extending between the gate region (140; 240; 340; 440) and the source and body regions.

10. The device of any of claims 6-9, comprising a nitride layer (290; 391) between the field plate oxide layer (220; 320) and the insulating layer (224, 225; 329, 328), the polysilicon region (230; 430) extending through the nitride layer.

11. The device of any of the preceding claims, wherein the air gap (160; 260; 360; 430) is surrounded by the insulating layer.

12. A method of manufacturing a power MOSFET device, comprising:

    forming a first insulating layer (325) on a substrate (110; 210; 310; 410) including a recess, the first insulating layer covering a first surface (112; 212; 312; 412) of the substrate, recess sidewalls (115; 215; 315), and a second surface (114; 214; 314; 414) of the recess extending between the sidewalls;
forming a polysilicon region (130; 230; 330; 430) in the first insulating layer; and
forming an air gap (160; 260; 360; 430) in the insulating layer on the substrate.

13. The method of the preceding claim, wherein forming the polysilicon region (130; 230; 330; 430) includes depositing a first polysilicon material (332) on the first insulating layer (325) and in the recess.

14. The method of claim 12 or 13, wherein forming the air gap (160; 260; 360; 430) includes etching the first insulating layer (325) and depositing a second insulating layer (329; 428) by a non-conformal process.

15. The method of the preceding claim, comprising forming a gate region (140; 240; 340; 440) by depositing a second polysilicon material on the second insulating layer (329; 428) and etching the second polysilicon material and forming source (118; 218; 318; 418) and body (116; 216; 316; 416) regions on the substrate.

FIG. 1

FIG. 2

FIG. 3A

FIG. 3B

FIG. 3C

FIG. 3D

EP 4 611 504 A1

FIG. 3E

FIG. 3F

FIG. 3G

**FIG. 3H**

EP 4 611 504 A1

FIG. 3I

EP 4 611 504 A1

FIG. 3J

FIG. 3K

FIG. 3L

FIG. 3M

FIG. 3N

FIG. 3O

EP 4 611 504 A1

FIG. 3P

EP 4 611 504 A1

FIG. 3Q

FIG. 3R

FIG. 4A

EP 4 611 504 A1

FIG. 4B

FIG. 4C

FIG. 4D

FIG. 4E

FIG. 4F

**EUROPEAN SEARCH REPORT**

Application Number

EP 25 15 7361

Europäisches
Patentamt
European
Patent Office
Office européen
des brevets

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 10 304 933 B1 (WOO SANGSU [KR] ET AL) 28 May 2019 (2019-05-28) * Figs. 1,2, 7 and correlated parts of the description * | 1-15 | INV. H10D30/01 H10D30/66 H10D62/10 H10D64/00 H10D64/27 |
| A | US 2022/157952 A1 (FUJINO YUHKI [JP]) 19 May 2022 (2022-05-19) * Figs. 1-16 and correlated parts of the description * | 8 | |
| A | US 9 722 071 B1 (SINOPOWER SEMICONDUCTOR INC [TW]) 1 August 2017 (2017-08-01) * Figs. 1-4 and correlated parts of the description * | 10 | |

TECHNICAL FIELDS
SEARCHED       (IPC)

H10D

The present search report has been drawn up for all claims

| Place of search | Date of completion of the search | Examiner |
|---|---|---|
| Munich | 11 July 2025 | Götz, Andreas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 15 7361

11-07-2025

| Patent document cited in search report | Publication date | Patent family member(s) | Publication date |
|---|---|---|---|
| US 10304933 B1 | 28-05-2019 | CN 110400843 A<br>US 10304933 B1 | 01-11-2019<br>28-05-2019 |
| US 2022157952 A1 | 19-05-2022 | CN 113410282 A<br>JP 7317752 B2<br>JP 2021150401 A<br>US 2021296454 A1<br>US 2022157952 A1 | 17-09-2021<br>31-07-2023<br>27-09-2021<br>23-09-2021<br>19-05-2022 |
| US 9722071 B1 | 01-08-2017 | NONE | |